# EUROPEAN PATENT APPLICATION

(11) **EP 1 349 209 A2**
(43) Date of publication of application: **01.10.2003**
(21) Application number: 03006548.6
(22) Date of filing: 24.03.2003
(51) Int. Cl.: H01L 23/34

(54) **Surveying device for the temperature of electronic components**

(30) Priority: 28.03.2002 IT TO20020277
(71) Applicant: BTM S.r.l., 10095 Grugliasco (Torino) (IT)
(72) Inventor: Giorgis, Wilmer, 10043 Orbassano (TO) (IT); Marchitto, Luciano, 10015 Ivrea (TO) (IT); Siciliano, Gaetano, 10135 Torino (IT)
(74) Representative: Lotti, Giorgio

(57) **Abstract**

Surveying device for the temperature of electronic components (2), the device (1) presenting a sensor (9) which is mounted in such a way as to form a bridge between two installation bump contacts (7), which are arranged on a component side (4) of a circuit board (3), and which are positioned on either side of a terminal (6) of the electronic component (2); the sensor (9) presenting a surveying central portion (10) which directly faces the terminal (6).

## Description

The present invention relates to a surveying device for the temperature of electronic components.

The device to which the present invention refers can be used to good advantage in the field of electronic components in general, and in the field of MOS components in particular, to which the description which follows will make specific reference without, however, losing any of its general nature.

Normally, the surveying of the temperature of MOS components is carried out by means of surveying devices which are, in some alternatives, directly integrated into the MOS component itself, while in other alternatives they comprise a sensor, which is mounted onto the same circuit board as that on which the MOS component is also mounted, and which is arranged in a proximal position to a terminal of the latter in order to detect the relative temperature.

The choice of the various kinds of alternatives depends on a series of technical or commercial needs, but in any case it has been found that one of the main defects which is common to the majority of these alternatives is defined by the influence that the temperature surrounding the circuit board can have on the correct surveying of the data concerning the temperature of the MOS component.

The aim of the present invention is to produce a surveying device for the temperature of electronic components which will be able to resolve the above-described disadvantages in a simple and cost-effective manner.

According to the present invention, a surveying device for the temperature of electronic components will be produced, the device comprising two installation bump contacts which are arranged on a circuit board, and a sensor which is mounted in such a way as to form a bridge between the two installation bump contacts, the device being characterised by the fact that the two installation bump contacts are arranged on either side of a terminal of the electronic component, and the sensor comprises a central surveying portion which directly faces the said terminal.

The invention will now be described with reference to the attached drawings, which illustrate a non-limiting form of embodiment of the present invention, in which:
- FIGURE 1 shows a plan view, with some parts removed for reasons of clarity, of a first preferred form of embodiment of a surveying device for the temperature of electronic components according to the present invention;
- FIGURE 2 shows a section along the line 11-11 which is shown in FIGURE 1;
- FIGURE 3 is an elevated side view, with some parts removed for reasons of clarity, of a second preferred form of embodiment of the surveying device for the temperature of electronic components which is illustrated in FIGURE 1;
- FIGURE 4 shows a section along the line IV-IV which is shown in FIGURE 3; and
- FIGURE 5 shows a plan view of a detail which is illustrated in FIGURE 4.

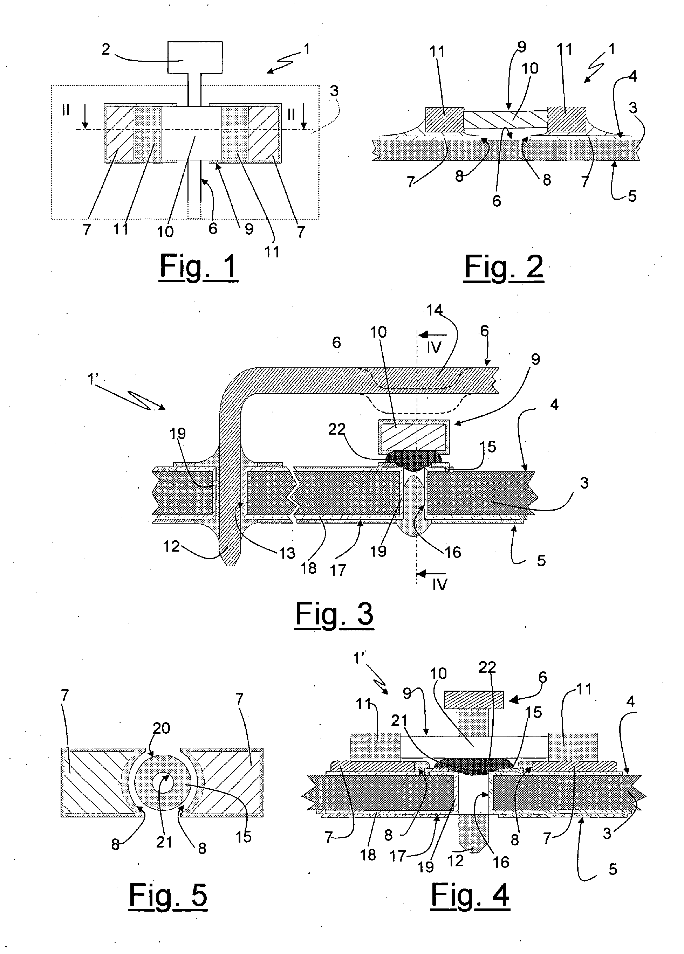

With reference to FIGURES 1 and 2, the number 1 indicates in its entirety a surveying device for the temperature of an MOS component 2, which is installed onto a circuit board 3 which is provided with a component side 4 and a welding side 5, and which comprises a so-called "drain'' terminal 6 which is arranged along the component side 4.

The device 1 comprises: two installation bump contacts 7 which are arranged on the component side 4 on either side of the terminal 6 and which are delimited in relation to each other by respective internal edges 8; and a sensor 9, which is mounted in such a way as to form a bridge between the two installation bump contacts 7, and which in turn comprises a surveying central portion 10 which directly faces the terminal 6, and two opposite end portions 11 which are welded onto the installation bump contacts 7 and which delimit the portion 10.

The portion 10 presents a working length which is greater than a distance between the two internal edges 8 of the installation bump contacts 7, which in their turn present a thickness of size which is negligible in relation to a thickness of the two end portions 11.

In this way it is possible both to position the central portion 10 as close as possible to the terminal 6 and to compensate for any errors in assembly by means of welding the sensor 9 onto the installation bump contacts 7.

The form of embodiment which is illustrated in FIGURES 3 - 5 relates to a surveying device 1' which is similar to the device 1, but from which the device 1' differs mainly due to the fact that the terminal 6 comprises an end portion 12 which is connected inside a passing housing 13 which is obtained through the circuit board 3, and an intermediate portion 14 which is arranged in a position directly overhanging the surveying central portion 10 of the sensor 9.

The device 1' comprises a circular crown 15, which is made of thermally conducting material and which is arranged on the component side 4 between the two installation bump contacts 7 in a position which is beneath the central portion 10. In particular, the crown 15 encircles the entrance of a further passing housing 16 which is obtained through the circuit board 3, and which is thermally connected to the portion 12 of the terminal 6 by means of a lining 17, which is part of the device 11, and which comprises a thermal conduction layer 18 which is arranged on the welding side 5 of the circuit board 3, and two thermal conduction bushings 19 which are housed inside the housings 13 and 16 and which are arranged in contact with the portion 12 and, respectively, the crown 15.

The crown 15, finally, is externally delimited by an external edge 20 which is equidistant from the internal edges 8, thus presenting, in this form of embodiment, an arched shape, and it is provided with an internal hole 21 which communicates with the housing 16.

In order to further increase the surveying capacity of the sensor 9 which, as described above, is substantially encircled by the intermediate portion 14 of the terminal 6 and by the crown 15, the device 11 comprises, finally, a deposit of material 22, which presents a thermal conduction which is greater than the thermal conduction of the air, and which is arranged in such a way as to close the hole 21.

In some applications which for example, reach high environmental temperatures, it could be necessary to further reduce the distance between the sensor 9 and the terminal 6, nevertheless, according to the illustration of the line as shown in FIGURE 3, the intermediate portion 14 of the terminal 6 is pre-shaped towards the surveying central portion 10 of the sensor 9 itself.

It is intended that the present invention should not be limited to the forms of embodiment herein described and illustrated, which are to be considered as examples of forms of embodiment of a surveying device for the temperature of electronic components, which might be subject to further modifications relating to the shape and disposition of parts, as well as details pertaining to construction and assembly.

## Claims

1. Surveying device (1) for the temperature of electronic components (2), the device (1) comprising two installation bump contacts (7) which are arranged on a circuit board (3), and a sensor (9) which is mounted in such a way as to form a bridge between the two installation bump contacts (7), the device (1) being **characterised by** the fact that the two installation bump contacts (7) are arranged on either side of a terminal (6) of the electronic component (2), and the sensor (9) comprises a central surveying portion (10) which directly faces the said terminal (6).

2. Surveying device according to Claim 1, **characterised by** the fact the sensor (9) comprises two opposite end portions (11) which are welded onto the installation bump contacts (7) and which delimit the said central surveying portion (10), which presents a working length which is greater than a distance between two internal edges (8) of the installation bump contacts (7) themselves.

3. Surveying device according to Claim 2, **characterised by** the fact that the two installation bumps (7) present a thickness of size which is negligible in comparison to a thickness of the two end portions (11), and the terminal (6) is arranged on the circuit board and the surveying central portion (10).

4. Surveying device according to Claim 2, **characterised by** the fact that it comprises a conductor element (15) which is arranged between the said two installation bump contacts (7) and which is thermally connected to a connecting point (12) of the terminal (6) in the circuit board (3).

5. Surveying device according to Claim 3, **characterised by** the fact that the conductor element (15) is defined by a circular crown (15), which is arranged on a component side (2) of the circuit board (3) in a position which is beneath the said surveying central portion (10), and which is limited on the outside by an external edge (20) which is equidistant from the internal edges (8) of the said two installation bump contacts (7).

6. Surveying device according to Claim 5, **characterised by** the fact that it comprises a thermally conducting layer (18) which is arranged on a welding side (5) of the circuit board (3) and which is connected to both the circular crown (15) and to the connecting point (12) of the terminal (6).

7. Surveying device according to Claim 6, **characterised by** the fact that it comprises a tubular connecting element (19) which is arranged through the circuit board (3) in order to connect the circular crown (15) to the conducting layer (18), and which is provided with a central passing hole (21).

8. Surveying device according to Claim 7, **characterised by** the fact that it comprises a deposit (22) of thermally conducting material which is greater than the thermal conduction of the air and which is arranged in such a way as to close the central hole (21) between the surveying central portion (19) and the circular crown (15).

9. Surveying device according to any of the above Claims from 2 to 8, **characterised by** the fact that the central surveying portion (10) is arranged in a position which is directly beneath that of the said terminal (6).

10. Surveying device according to Claim 9, **characterised by** the fact that the said terminal (6) comprises an intermediate portion (14) which is pre-shaped towards the surveying central portion (10) of the sensor (9).
